# EUROPEAN PATENT APPLICATION

(11) **EP 0 748 046 A2**
(43) Date of publication of application: **11.12.1996**
(21) Application number: 96109188.1
(22) Date of filing: 07.06.1996
(51) Int. Cl.: H03K 19/00

(54) **Connection of high going and low going transitions**

(30) Priority: 07.06.1995 US 479741
(71) Applicant: TEXAS INSTRUMENTS INCORPORATED, Dallas Texas 75265 (US)
(72) Inventor: Houston,Theodore W., Richardson, TX 75080 (US)
(74) Representative: Schwepfinger, Karl-Heinz, Dipl.-Ing.

(57) **Abstract**

A circuit (5) which recognizes when each of two outputs which are presently in opposite charge states or differentially charged are both to be concurrently switched to the opposite state. The outputs are then initially connected together to equalize the state of each output at a state somewhere between the two original states and then disconnected from each other with the outputs then being altered to the opposite state. The structure required senses the present state of each output at a pair of terminals (1,3) and the state of the new input to each of the terminals (1,3) in a logic circuit. When the logic circuit determines that the state of each terminal is to be changed to the opposite state, it opens a pass gate (33) between the two terminals (1,3) to equalize the states of the two terminals (1,3) somewhere between the original state of each terminal (1,3) and then closes the pass gate (33). A tristate driver is then conditioned by the logic circuit to provide a signal to each of the terminals (1,3) which requires about one half of the power that would have been required for a complete change of state, thereby conserving power. If the logic circuit recognizes that both terminals (1,3) being monitored are not to be switched to their opposite state, then the tristate driver is conditioned to operate in standard manner and provide a full signal to each terminal (1,3) with the pass gate (33) remaining in the open condition.

## Description

### BACKGROUND OF THE INVENTION

### FIELD OF THE INVENTION

This invention relates to a switching circuit to identify when the charge states at a predetermined pair of oppositely charged terminals are to concurrently switch in opposite directions and to utilize the charge on one of the discharging terminals to partially charge the other of the terminals which is to be charged.

### BRIEF DESCRIPTION OF THE PRIOR ART

In general, when the charge state of a terminal is to be changed from one of two possible states to the other of the two possible states, the charge fed to that terminal is such as to cause a complete alteration of the charge state of that terminal from a first of the two possible states to the other of the two states. This requires a charge output at least equal to the full state change and can require large amounts of power consumption. It is desireable, especially in integrated circuit technology, to reduce the power requirements of the circuitry for many well known reasons and one method of reducing the power requirement would be to minimize the charge consumption required for charge state changes.

In integrated circuits with differential signals, where it is known that when the state of one of two terminals is being changed the other of the two terminals will always change concurrently in the opposite direction, circuitry has been provided to equalize the charge states of the two associated terminals by interconnection of the terminals prior to switching the states of both terminals. This procedure saves energy, however it is operational for all changes in energy state and is applied to both of the terminals for every energy state change. The reason is that both terminals always concurrently switch differentially in the prior art circuits, such as memory devices with differential signal lines, so the circuitry does not have to recognize and therefore does not recognize when the state of only one of the two terminals is to be changed.

### SUMMARY OF THE INVENTION

In accordance with the present invention, there is provided a circuit which overcomes the problems of the prior art in that it is operational with terminal pairs that do not always concurrently switch differentially or in opposite directions together and also provides energy conservation.

Briefly, in accordance with the present invention, a circuit is provided which recognizes when each of two outputs are presently in opposite charge states, such as a high voltage state and a low voltage state, a positively charged state and a relatively negatively charged state or the like and are both to be concurrently switched to the opposite charge state. The charge levels on the outputs or energizable terminals are then initially connected together to equalize the charge state of each output at a state somewhere between the two original charge states. The energizable terminals are then disconnected from each other with the charge levels on these terminals then being altered to the opposite state. It can be seen that the power or energy required to alter the charge states of the energizable terminals will now be approximately one half of the power required of equivalent prior art circuits.

The logic circuitry required senses the present charge state of each output at a pair of energizable terminals and the charge state of the new input to each of the terminals in the logic circuit. When the logic circuit determines that the charge state of each energizable terminal is to be changed to the opposite of the two available charge states, it opens a pass gate between the two terminals to equalize the charge states of the two terminals somewhere between the original charge state of each terminal and then closes the pass gate. A standard tristate driver, which generally provides one of a high output, a low output or a high impedance, is then conditioned by the logic circuit to provide a signal to each of the terminals which requires about one half of the charge that would have been required for a complete change of state, thereby conserving power. If the logic circuit recognizes that both energizable terminals being monitored are not to be switched to their opposite charge state, then the tristate driver is conditioned to operate in standard manner and provide a full charge level signal to each energizable terminal with the pass gate remaining in the open condition.

Another option is to have the driver, which need not be a tristate driver, and the pass gate all on initially and then turn the pass gate off at about the time of charge equalization. The turning off of the pass gate is based upon feedback from the lines being equalized or based upon timing.

The invention can be applied to more than two energizable terminals concurrently by using an additional system of the type described above between one of the energizable terminals monitored by the above described system and a further energizable terminal. Also, when more than two energizable terminals are being monitored in the manner above described, one logic circuit can be provided to monitor more than two of the terminals with appropriate circuitry alterations.

### BRIEF DESCRIPTION OF THE DRAWINGS

FIGURE 1 is a circuit diagram in accordance with a first embodiment of the present invention;
FIGURE 2 is a circuit diagram in accordance with a second embodiment of the present invention; and
FIGURES 3a and 3b are circuit diagram of logic circuits which can be used in the block 5 of FIGURE 1.

### DESCRIPTION OF THE PREFERRED EMBODIMENT

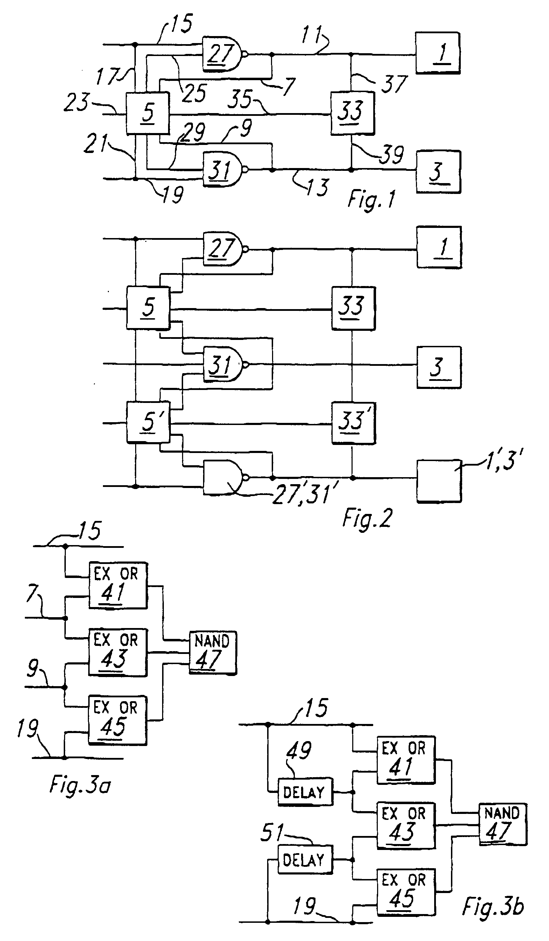

Referring to FIGURE 1, there are shown two terminals 1 and 3 which are chargeable to one of two possible energy levels or charge states such as, for example, positive and negative, ground and positive, ground and negative, positive and more positive, negative and more negative, etc. A logic circuit 5 is coupled to terminal 1 via conductors 7 and 11 and to terminal 3 via conductors 9 and 13 whereby logic circuit 5 is aware of the current charge state of each of terminals 1 and 3. The logic circuit 5 is also coupled to an input conductor 15 via conductor 17 and to input conductor 19 via conductor 21 whereby the logic circuit is aware of the charge state to be provided to terminals 1 and 3 when the next output enable signal is provided thereto at the output enable input 23. The input conductor 15 as well as an output 25 from the logic circuit 5 are connected to the input of a tristate driver 27, the output of the driver 27 being coupled to the conductor 11 whereas the input conductor 19 as well as an output 29 from the logic circuit 5 are connected to the input of a tristate driver 31, the output of the driver 31 being coupled to the conductor 13. The logic circuit 5 also controls a pass gate 33 via a conductor 35, the pass gate 33 being coupled to the conductor 11 via a conductor 37 and to conductor 13 via a conductor 39.

When an output enable signal is provided to the logic circuit 5 on the output enable line 23, the logic circuit 5 initially senses lines 7 and 9 to determine whether the charges on terminals 1 and 3 are of opposite possible charge state. If it is determined that they are of opposite charge state, then or concurrently the charge state on the input lines 15 and 19 is sensed to determine if they are also of opposite charge state and are also set to change the charge state on each of terminals 1 and 3. If a negative result is obtained in either case, a signal is sent along the line 25 to the driver 27 and along the line 29 to the driver 31 to provide a standard full charge to the terminals 1 and 3 to change the charge on each of terminals 1 and 3 to the opposite energy state and a signal is concurrently provided on conductor 35 from logic circuit 5 to maintain the pass gate 33 in the closed or non-conducting state. If a positive result is obtained in both cases, a signal is initially sent along the conductor 35 to open the pass gate 33 and allow the charges on terminals 1 and 3 to substantially equalize by having charge pass from one of the terminals 1 and 3 to the other of the terminals 1 and 3 via conductors 37 and 39 and open pass gate 33. The pass gate 33 is then closed via the signal on conductor 35 and logic circuit 5 then passes a signal along the line 25 to the tristate driver 27 and along the line 29 to tristate driver 31 to supply charge to complete the transition to the desired state. In this way, there is a power saving in all cases where both terminals are being switched concurrently to the opposite energy state.

The above described circuitry can be used when more than two lines are being monitored in the same manner by utilizing additional circuitry identical to that of FIGURE 1 including an additional logic circuit 5', a driver 27' or 31' and a pass gate 33' as shown in FIGURE 2. In this case, there is a saving of circuitry since the tristate driver 31' can be used in conjunction with logic circuit 5' as shown in FIGURE 2 or in conjunction with logic circuit 5 if connected therewith in the same manner as it is shown connected to logic circuit 5'. As a first alternative, a third logic gate and pass gate can be connected between the top and bottom circuits to operate in conjunction with those circuits in the same manner as discussed with respect to the circuits shown in FIGURES 1 and 2. In the case of the first alternative, in the event the charge along all three circuits is to be altered, it is apparent that two of the circuits will undergo the same change. Accordingly, either the pass gate from one of those circuits will not be opened and that circuit will receive an increased charge or both pass gates will be opened and closed with the charge provided to each terminal being about two thirds of the normal charge provided. It should be understood that the charge at each terminal need not be identical but merely sufficient to perform its function for the required charge level thereat.

Referring now to FIGURE 3a, there is shown a typical logic circuit 5 of FIGURE 1 or FIGURE 2. The circuit includes a NAND gate 47 which is fed by exclusive OR gates 41, 43 and 45. The inputs to gate 41 are the first input along line 15 and feedback from the output of tristate driver 27 whereas the inputs to gate 43 are the feedback from the outputs of tristate drivers 27 and 31 and the inputs to gate 45 are the second input along line 19 and feedback from the output of tristate driver 31. The output of the gate 47 is fed to the pass gate 33. FIGURE 3b is identical to FIGURE 3a except that delay circuits 49 and 51 are introduced from the input lines 15 and 19 respectively to the gates 41 and 45 respectively in place of the feedback from the outputs of the tristate drivers to these gates.

Though the invention has been described with respect to specific preferred embodiments thereof, many variations and modifications will immediately become apparent to those skilled in the art. For example, the enabling of the tristate drivers can be concurrent with the transfer of charge between the terminals being switched. Further, the tristate drivers can be replaced with two state drivers with the transfer of charge between the terminals being switch controlled to occur during the first part of the transition.

## Claims

1. A logic system which comprises:
(a) first and second energizable terminals, each of said first and second energizable terminals being energizable to each of two different charge states;
(b) first and second input terminals providing an indication of the desired charge state of said first and second energizable terminals; and
(c) logic circuitry responsive to a desired differential concurrent change of charge state of both said first and second energizable terminals to transfer charge between said first and second energizable terminals and to change the charge states of said first and second energizable terminals to said desired charge state.

2. The logic system of claim 1 wherein said logic circuitry includes means to energize each of said energizable terminals with an amount of charge responsive to the charge states of said first and second energizable terminals and said first and second input terminals.

3. The logic system of any of claims 1-2, further including a pass gate coupled between said first and second energizable terminals and controlled by said logic circuitry to provide said transfer of charge between said first and second energizable terminals.

4. The logic system of any of claims 2-3, wherein said means to energize comprises a tristate driver.

5. The logic system of claim 4 wherein said means to energize comprises a tristate driver capable of providing charge levels to each of said energizable terminals.

6. The logic system of any of claims 1-5, wherein said transfer of charge is prior to said charging of said first and second energizable terminals to said charge state.

7. A logic method which comprises the steps of:
(a) providing first and second energizable terminals, each of said first and second energizable terminals being energizable to each of two different charge states;
(b) providing first and second input terminals providing an indication of the desired charge state of said first and second energizable terminals;
(c) transferring charge between said energizable terminals; and
(d) changing the charge states of said first and second energizable terminals to said desired charge state.

8. The method of claim 7 wherein said step of transferring charge between said first and second energizable terminals is responsive to a desired concurrent change of charge state of both said first and second energizable terminals.

9. The method of any of claims 7-8 wherein said changing step includes the step of energizing each of said energizable terminals with an amount of charge determined by the charge states of said first and second energizable terminals and said first and second input terminals.

10. The method of any of claims 7-9 further including providing a pass gate coupled between said first and second energizable terminals and controlled by said logic circuitry to provide said transfer of charge between said first and second energizable terminals.

11. The method of any of claims 9-10, wherein the step of energizing each of said energizable terminals with an amount of charge determined by the charge states of said first and second energizable terminals and said first and second input terminal includes the step of providing a tristate driver capable of providing two different charge levels to each of said energizable terminals.

12. The method of any of claims 7-11 wherein the step of transferring charge between said energizable terminals occurs prior to the step of changing the charge states of said first and second energizable terminals to said desired charge state.
